# EUROPEAN PATENT APPLICATION

(11) **EP 1 531 565 A1**
(43) Date of publication of application: **18.05.2005**
(21) Application number: 02743830.8
(22) Date of filing: 04.07.2002
(51) Int. Cl.: H04J 1/00

(54) **RADIO RECEIVER**

(71) Applicant: FUJITSU LIMITED, Kawasaki-shi, Kanagawa 211-8588 (JP)
(72) Inventor: SHIBUYA, Yasuhiro, Sapporo-shi, Hokkaido 060-0807 (JP)
(74) Representative: Stebbing, Timothy Charles
(86) International application number: PCT/JP2002/006788
(87) International publication number: WO 2004/006476

(57) **Abstract**

The invention relates to a radio receiver that demultiplexes a multiplex signal having an occupied band in the submillimeter wave band or a higher frequency band and enables channel-by-channel heterodyne detection. An object of the invention is to attain high transmission quality at a low cost without the need for changing the configuration to a large extent. To this end, in a radio receiver according to the invention, automatic gain controls are performed parallel on signals of respective channels obtained by demultiplexing and frequency conversions by using, as a reference, a maximum one of the levels of those signals.

## Description

### TECHNICAL FIELD

The present invention relates to a radio receiver that enables channel-by-channel heterodyne detection by demultiplexing a multiplex signal that was generated according to a frequency multiplexing method and has an occupied band in the submillimeter wave band or a higher frequency band.

### BACKGROUND ART

In recent years, the number of subscribers of mobile communication networks has increased greatly and their service areas have expanded so as to include wide areas that are distributed around city areas.

Conventionally, many of access systems to be formed between such a mobile communication network and a trunk communication network are constructed by employing multiplex radio apparatus that operate according to a frequency multiplexing method.

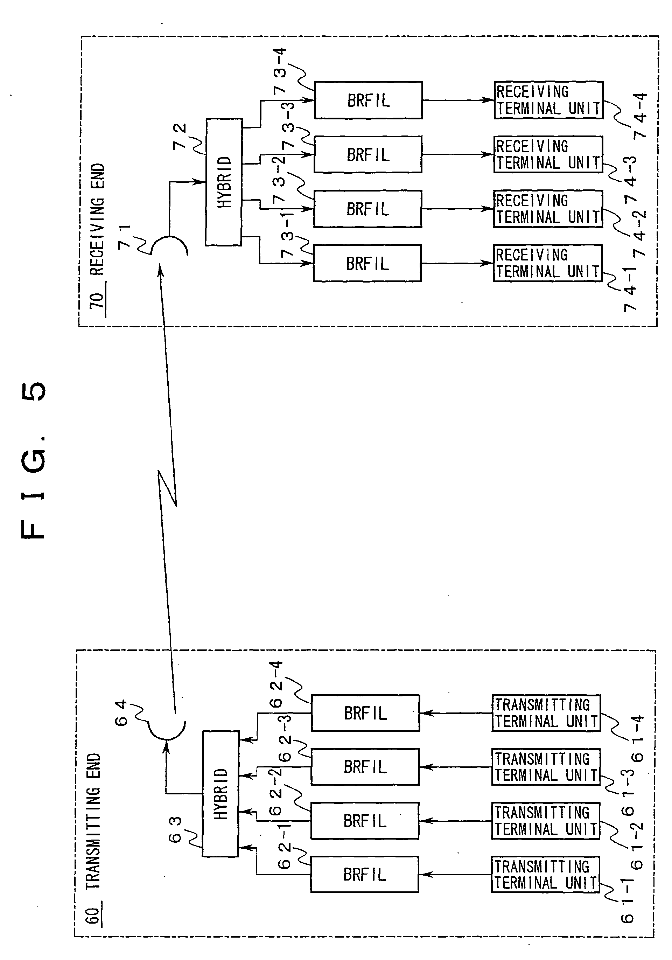

Fig. 5 shows the configuration of a conventional access system.

As shown in Fig. 5, the access system is formed between a transmitting end 60 and a receiving end 70 that are installed at two different sites, respectively, that are distant from each other geographically. In the following description, for the sake of simplicity, it is assumed that the transmitting end 60 and the receiving end 70 are provided in multiplex radio receivers that are installed at the above-mentioned two respective sites.

The transmitting end 60 is composed of the following components:
- Transmitting terminal units 61-1 to 61-4 that are provided in a number that is equal to a desired degree of multiplexing (assumed here to be equal to 4 for the sake of simplicity).
- Branching filters (BRFIL) 62-1 to 62-4 that are cascade-connected to the outputs of the transmitting terminal units 61-1 to 61-4, respectively.
- Hybrid 63 having first to fourth terminals that are connected to the outputs of the branching filters 62-1 to 62-4, respectively.
- Antenna 64 whose feeding point is connected to a fifth terminal of the hybrid 63.
The receiving unit is composed of the following components:
- Antenna 71
- Hybrid 72 having a first terminal that is connected to the feeding point of the antenna 71.
- Branching filters 73-1 to 73-4 having inputs that are connected to second to fifth terminals of the hybrid.
- Receiving terminal units 74-1 to 74-4 that are cascade-connected to the respective branching filters 73-1 to 73-4.

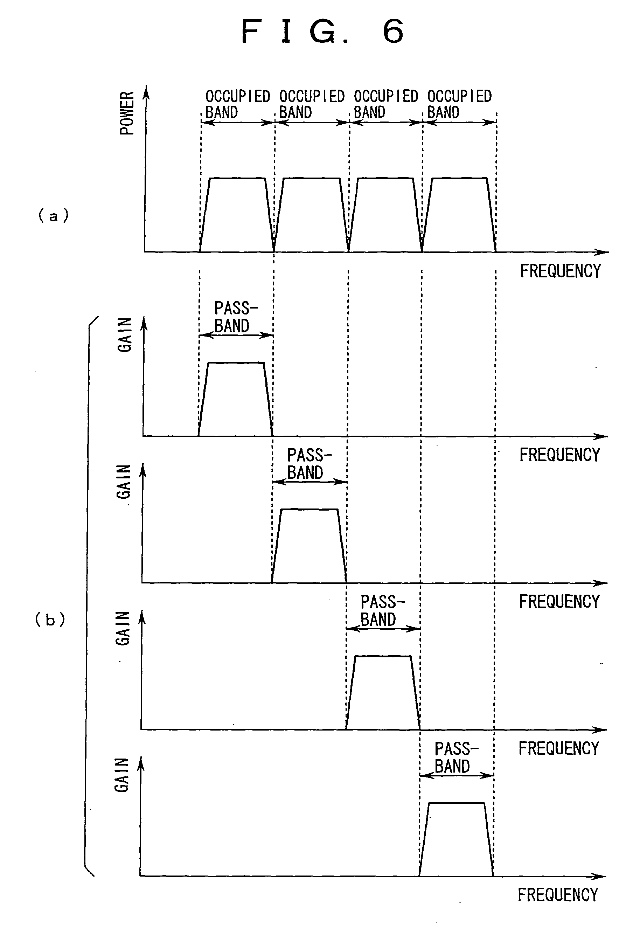

In the transmitting end 60 having the above configuration, the transmitting terminal units 61-1 to 61-4 output first to fourth radio-frequency signals that are modulated by pieces of transmission information to be transmitted parallel on four channels corresponding to the respective transmitting terminal units 61-1 to 61-4 and whose occupied bands are arranged adjacent to each other on the frequency axis without any overlaps as shown in Fig. 6(a).

Having respective pass-bands shown in Fig. 6(b), the branching filters 62-1 to 62-4 reject signals other than the first to fourth radio-frequency signals.

The hybrid 63 generates a transmission wave signal by frequency-multiplexing the first to fourth signals that are supplied parallel after being subjected to the above filtering processing and that have the different occupied bands that are adjacent to each other on the frequency axis, and supplies the generated transmission wave signal to the feeding end of the antenna 64. In the following description, for the sake of simplicity, a radio-frequency signal that is radiated from the antenna 64 will be referred to simply as "radio-frequency signal."

On the other hand, in the receiving end 70, the antenna 71 receives a radio-frequency signal that comes from the antenna 64 via a radio transmission channel formed between the antennas 64 and 71, and distributes the received radio-frequency signal to the branching filters 73-1 to 73-4 in parallel via the hybrid 72.

The branching filters 73-1 to 73-4 have the same pass-bands as the branching filters 62-1 to 62-4, respectively, that are provided in the transmitting end 60. The branching filters 73-1 to 73-4 demultiplex the distributed radio-frequency signal by performing, in parallel, the same filtering processing as described above on the radio-frequency signal, and thereby extract, in parallel, the first to fourth radio-frequency signals that are frequency-multiplexed as the above radio-frequency signal.

The receiving terminal units 74-1 to 74-4 restore the pieces of transmission information that have been transmitted parallel on the above four channels by performing, on the extracted first to fourth radio-frequency signals, processing that is reverse to the processing that was performed in the transmitting terminal units 61-1 to 61-4 provided in the transmitting end 60.

Therefore, a communication link having a desired degree of multiplexing formed according to the frequency multiplexing method between the respective sites where the transmitting end 60 and the receiving end 70 are installed.

Incidentally, in the above conventional example, where a radio transmission channel is to be formed between the antennas 64 and 71 in the submillimeter wave band or a higher frequency band (e.g., a 18-GHz band), in general, the ratio (hereinafter referred to as "bandwidth ratio") of the width of the transmission bands of the branching filters 62-1 to 62-4 and 73-1 to 73-4 to the carrier wave frequency increases as the frequency band goes higher.

Therefore, with regard to the branching filters 62-1 to 62-4 and 73-1 to 73-4, it becomes more difficult technically to realize desired sharp pass-bands as the frequency band goes higher. Even when such pass-bands can be realized technically, they cannot be realized easily because of increase in circuit scale and cost restrictions that relate to implementation etc.

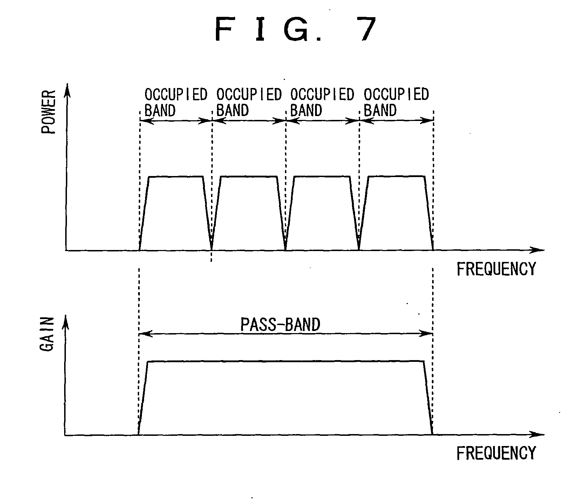

For example, a radio transmission channel as mentioned above can be formed in the submillimeter wave band or a higher frequency band by providing, as the branching filters 62-1 to 62-4 or 73-1 to 73-4, a filter whose pass-band covers the entire band of the four occupied bands as shown in Fig. 7.

However, in the above configuration, in practice, when the levels of reception waves of the respective channels vary individually or deviations occur between those levels, an automatic gain control that is performed in the branching filters 73-1 to 73-4 or the receiving terminal units 74-1 to 74-4 provided in the receiving end 70 to compress such variations of or deviations between those levels is performed with the sum of those levels used as a reference.

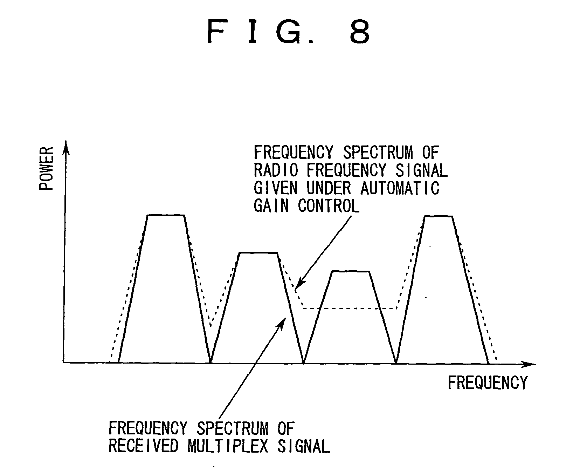

That is, it is probable that interchannel interference occurs between radio-frequency signals of the respective channels (indicated by a broken line in Fig. 8) and the transmission quality is much lowered.

In general, the costs relating to the installation, maintenance, and operation of a mobile communication network as mentioned above increase as the service area becomes wider. In particular, the cost ratio of an access system including a communication link between a mobile communication network and a trunk communication network increases.

Further, with the putting into practical use of the wideband CDMA, services to be provided to subscribers of a mobile communication network are rapidly expanding so as to include not only to telephonic communication services but also a variety of broadband communication services.

Therefore, access systems as mentioned above are strongly required to employ a frequency that is in the submillimeter wave band or a higher frequency band and is advantageous in the following points:
- Less prone to deterioration in transmission quality due to a multipath phenomenon etc.
- Enables simplification or omission of transmission channel coding that is necessary for securing sufficient transmission quality.
- Enables flexible adaptation to a high degree of multiplexing and reuse of frequencies.

### DISCLOSURE OF THE INVENTION

An object of the present invention is to provide a radio receiver capable of attaining multiplex transmission of a desired high degree of multiplexing in the submillimeter wave band or a higher frequency band with high transmission quality without the need for changing the configuration to a large extent.

Another object of the invention is to secure an occupied band of each of multiplexed signals of an input signal with high reliability through filtering processing using a pass-band having the same width as the occupied band width and to avoid interchannel interference stably with high reliability.

Another object of the invention is to keep the transmission quality high and to enable flexible adaptation to a variety of profiles of radio transmission channels and wireless zones.

Still another object of the invention is to reduce a level difference of each of multiplexed signals of an input signal without distorting each multiplexed signal unduly and to convert each multiplexed signal into a desired intermediate frequency signal.

Yet another object of the invention is to secure a high degree of freedom in setting a level diagram or allocating gains without lowering the SN ratios or the transmission quality excessively.

A further object of the invention is to keep the SN ratios and the transmission quality high even when the frequency at which the gains of frequency converting sections should be updated is close to the cycle of symbols that are represented by individual multiplexed signals of an input signal.

The above objects are attained by a radio receiver characterized in that a particular output signal having a maximum level is selected from among a plural number n of first output signals generated by frequency-converting a plural number n of frequency-multiplexed signals, respectively, and that the gains of sections performing the frequency conversions are kept in parallel at such a value that a deviation of a level of the particular output signal is compressed.

In this radio receiver, even when level differences occur between the plural number n of signals due to characteristics of a transmission channel, a transmitting end, etc. or variations of those characteristics, the plural number n of signals are frequency-converted individually in parallel and intermediate frequency signals having approximately the same level are obtained from those signals under automatic gain controls that are performed by using, as a reference, a maximum one of the levels of those signals. The intermediate frequency signals are subjected to demodulation (detection).

During the above automatic gain controls, all the input/output characteristics of the sections performing the frequency conversions are kept linear as long as a proper level diagram holds that conforms to a standard input level of the plural number n of signals.

Further, even where the plural number n of signals are given at different levels in the submillimeter wave band or a higher frequency band, in the process of the above-mentioned frequency conversions the bandwidth ratios of the respective occupied bands of the plural number n of signals are made small values flexibly and stably.

The above objects are attained by a radio receiver characterized in that a level of a particular signal having highest transmission quality is selected from among levels of a plural number n of first output signals generated by frequency-converting a plural number n of frequency-multiplexed signals, respectively, and that the gains of sections performing the respective frequency conversions are kept parallel at such a value that a difference between the selected level and a maximum level of signals for which all input/output characteristics of those sections can be regarded as linear among the plural number n of signals is compressed.

In this radio receiver, even when level or transmission quality differences occur between the plural number n of signals due to characteristics of a transmission channel, a transmitting end, etc. or variations of those characteristics, the plural number n of signals are frequency-converted individually in parallel and intermediate frequency signals having approximately the same level are obtained from those signals under automatic gain controls that are performed by using, as a reference, the level of a signal having highest transmission quality among those signals. The intermediate frequency signals are subjected to demodulation (detection).

During the above automatic gain controls, all the input/output characteristics of the sections performing the frequency conversions are kept linear as long as a proper level diagram holds that conforms to a standard input level of the plural number n of signals.

Further, even where the plural number n of signals are given at different levels in the submillimeter wave band or a higher frequency band, in the process of the above-mentioned frequency conversions the bandwidth ratios of the respective occupied bands of the plural number n of signals are made small values flexibly and stably.

The above objects are attained by a radio receiver characterized in that level variations of the plural number n of first output signals are suppressed individually and second output signals corresponding to the first output signals are thereby generated, and that when the level of a second output signal is lower than a prescribed lower limit value, the gain is kept at such a value that the deviation of the level of the second output signal is compressed.

In this radio receiver, when a second output signal is excessively small, the gain of the section that has generated a first signal corresponding to the second output signal is kept locally at such a value that the deviation of the second output signal is suppressed irrespective of the levels of the other first signals.

The above objects are attained by a radio receiver characterized in that level variations of the plural number n of first output signals are suppressed individually and second output signals corresponding to the first output signals are thereby generated, and that when the level of a second output signal is lower than a prescribed lower limit value, the gain is kept at such a value that the difference between the level of the second output signal and a maximum level of signals for which all input/output characteristics of the sections performing the frequency conversions among the plural number n of signals can be regarded as linear among the plural number n of signals is compressed.

In this radio receiver, when a second output signal is excessively small, the gain of the section that has generated a first signal corresponding to the second output signal is kept at such a value that the deviation of the second output signal is suppressed irrespective of the levels of the other first signals.

The above objects are attained by a radio receiver characterized in that level variations of the plural number n of first output signals are suppressed individually and second output signals corresponding to the first output signals are thereby generated, and that when the deviation of the level of the particular output signal is larger than a prescribed threshold value and the level of a second output signal is lower than a prescribed lower limit value, the gain is kept at such a value that the deviation of the level of the second output signal is compressed.

In this radio receiver, only when the deviation of the level of the particular output signal is larger than the prescribed threshold value and a second output signal is excessively small, the gain of the section that has generated a first signal corresponding to the second output signal is kept at such a value that the deviation of the second output signal is suppressed irrespective of the levels of the other first signals.

The above objects are attained by a radio receiver characterized in that level variations of the plural number n of first output signals are suppressed individually and second output signals corresponding to the first output signals are thereby generated, and that when the deviation of the selected level is larger than a prescribed threshold value and the level of a second output signal is lower than a prescribed lower limit value, the gain is kept at such a value that the difference between the level of the second output signal and a maximum level of signals for which all input/output characteristics of the sections performing the frequency conversions among the plural number n of signals can be regarded as linear among the plural number n of signals is compressed.

In this radio receiver, when a second output signal is excessively small, the gain of the section that has generated a first signal corresponding to the second output signal is kept at such a value that the deviation of the second output signal is suppressed irrespective of the levels of the other first signals.

The above objects are attained by a radio receiver characterized in that the gains are varied within such ranges where decreases in SN ratios of the plural number n of first output signals are permitted.

In this radio receiver, even when the level of one of the plural number n of signals has become much higher or lower than the levels of the other signals for a certain reason, the sections performing the frequency conversions operate stably in ranges where the input/output characteristics are linear.

The above objects are attained by a radio receiver characterized in that the gains are varied within such ranges that a desired noise figure is secured.

In this radio receiver, even when the level of one of the plural number n of signals has become much lower than the levels of the other signals for a certain reason, the gains of the sections performing the frequency conversions are updated in such ranges that the desired noise figure is secured comprehensively.

The above objects are attained by a radio receiver characterized in that the gains are updated in synchronism with sequences of symbols that are represented by the plural number n of signals, respectively.

In this radio receiver, the gains of the sections performing the frequency conversions are updated at prescribed time points that are synchronized with respective symbol positions on which decision should be made in a process of decision decoding that is performed at a stage downstream of those sections.

### BRIEF DESCRIPTION OF THE DRAWINGS

Fig. 1 is a block diagram showing the principles of operation of radio receivers according to the present invention;
Fig. 2 shows first, second, and fourth embodiments of the invention;
Fig. 3 illustrates the operation of the first embodiment of the invention;
Fig. 4 shows a third embodiment of the invention;
Fig. 5 shows the configuration of an exemplary multiplex radio apparatus that is used for constructing an access system;
Fig. 6 illustrates the operation of the conventional example;
Fig. 7 is a first diagram illustrating a problem of the conventional example; and
Fig. 8 is a second diagram illustrating the problem of the conventional example.

### BEST MODE FOR CARRYING OUT THE INVENTION

First, the principles of operation of radio receivers according to the present invention will be described.

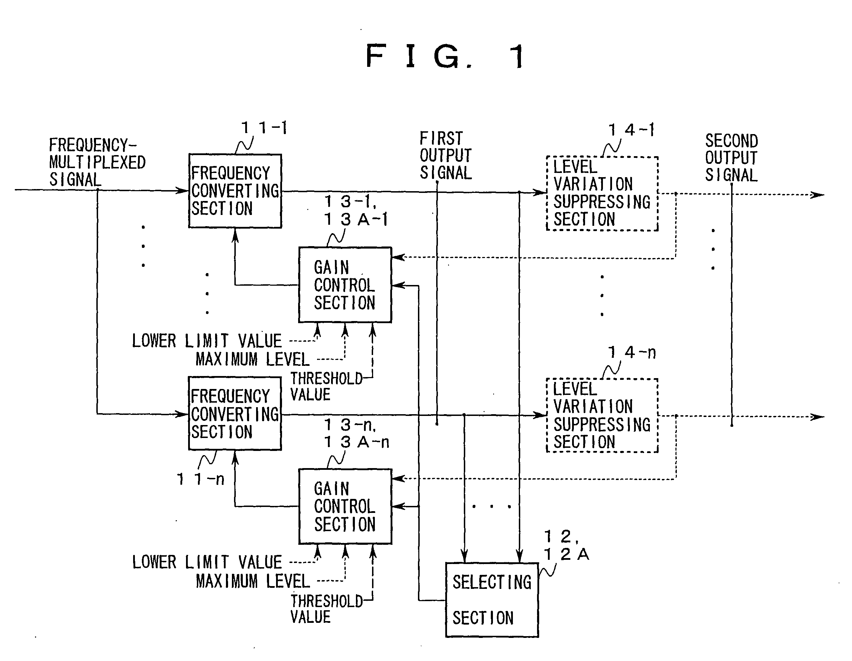

Fig. 1 is a block diagram showing the principles of operation of radio receivers according to the invention.

The radio receivers shown in Fig. 1 are composed of frequency converting sections 11-1 to 11-n, a selecting section 12 or 12A, gain control sections 13-1 to 13-n or 13A-1 to 13A-n, and level variation suppressing sections 14-1 to 14-n.

The principle of operation of a first radio receiver according to the invention is as follows.

The plural number n of frequency converting sections 11-1 to 11-n frequency-convert a plural number n of frequency-multiplexed signals, respectively, and thereby generate a plural number n of first output signals corresponding to the respective frequency-multiplexed signals. The selecting section 12 selects a particular output signal having a maximum level from among the plural number n of first output signals. The plural number n of gain control sections 13-1 to 13-n keep gains of the plural number n of frequency converting sections 11-1 to 11-n in parallel at such a value that a deviation of a level of the particular output signal is compressed.

That is, even when level differences occur between the plural number n of signals due to characteristics of one of a transmission channel, a transmitting end, and the frequency converting sections 11-1 to 11-n or variations of those characteristics, the plural number n of signals are frequency-converted individually in parallel and intermediate frequency signals having approximately the same level are obtained from those signals under automatic gain controls that are performed by using, as a reference, a maximum one of the levels of those signals. The intermediate frequency signals are subjected to demodulation (detection).

During the above automatic gain controls, all the input/output characteristics of the frequency converting sections 11-1 to 11-n are kept linear as long as a proper level diagram holds that conforms to a standard input level of the plural number n of signals.

Further, even where the plural number n of signals are given at different levels in the submillimeter wave band or a higher frequency band, in the process of the above-mentioned frequency conversions the bandwidth ratios of the respective occupied bands of the plural number n of signals are made small values flexibly and stably.

Therefore, in the process of the above-mentioned frequency conversions, the occupied bands are secured with high reliability through filtering processing using pass-bands having the same width as the occupied band width and interchannel interference is avoided stably with high reliability.

The principle of operation of a second radio receiver according to the invention is as follows.

The plural number n of frequency converting sections 11-1 to 11-n frequency-convert a plural number n of frequency-multiplexed signals, respectively, and thereby generate a plural number n of first output signals corresponding to the respective frequency-multiplexed signals. The selecting section 12A selects a level of a particular signal having highest transmission quality from among levels of the plural number n of first output signals. The plural number n of gain control sections 13A-1 to 13A-n keep gains of the plural number n of frequency converting sections 11-1 to 11-n, respectively, at such a value that a difference between the level selected by the selecting section 12A and a maximum level of signals for which all input/output characteristics of the plural number n of frequency converting sections 11-1 to 11-n can be regarded as linear among the plural number n of signals is compressed.

That is, even when level or transmission quality differences occur between the plural number n of signals due to characteristics of one of a transmission channel, a transmitting end, and the frequency converting sections 11-1 to 11-n or variations of those characteristics, the plural number n of signals are frequency-converted individually in parallel and intermediate frequency signals having approximately the same level are obtained from those signals under automatic gain controls that are performed by using, as a reference, the level of a signal having highest transmission quality among those signals. The intermediate frequency signals are subjected to demodulation (detection).

During the above automatic gain controls, all the input/output characteristics of the frequency converting sections 11-1 to 11-n are kept linear as long as a proper level diagram holds that conforms to a standard input level of the plural number n of signals.

Further, even where the plural number n of signals are given at different levels in the submillimeter wave band or a higher frequency band, in the process of the above-mentioned frequency conversions the bandwidth ratios of the respective occupied bands of the plural number n of signals are made small values flexibly and stably.

Therefore, in the process of the above-mentioned frequency conversions, the occupied bands are secured with high reliability through filtering processing using pass-bands having the same width as the occupied band width and interchannel interference is avoided stably with high reliability.

The principle of operation of a third radio receiver according to the invention is as follows.

The plural number n of level variation suppressing sections 14-1 to 14-n suppress level variations of the plural number n of first output signals, respectively, and thereby generate second output signals corresponding to the first output signals. When the level of a second output signal generated by one of the plural number n of level variation suppressing sections 14-1 to 14-n is lower than a prescribed lower limit value, the plural number n of gain control sections 13-1 to 1 3-n keep the gain of a corresponding one of the plural number n of frequency converting sections 11-1 to 11-n at such a value that a deviation of the level of the second output signal, instead of the level of the particular output signal, is compressed.

That is, when a second output signal generated even under automatic gain controls performed by the level variation suppressing sections 14-1 to 14-n is excessively small, the gain of the frequency converting section that has generated the corresponding first signal is kept by the gain control sections corresponding to the first signal (i.e., frequency converting sections) at such a value that the deviation of the second output signal is suppressed irrespective of the levels of the other first signals.

Therefore, the transmission quality can be kept higher and more flexible adaptation to a variety of profiles of radio transmission channels and wireless zones can be made than in a case that a variation or difference of the level of each of the plural number n of signals is reduced or compressed under an automatic gain control based on a maximum one of the levels of those signals.

The principle of operation of a fourth radio receiver according to the invention is as follows.

The plural number n of level variation suppressing sections 14-1 to 14-n suppress level variations of the plural number n of first output signals, respectively, and thereby generate second output signals corresponding to the first output signals. When the level of a second output signal generated by one of the plural number n of level variation suppressing sections 14-1 to 14-n is lower than a prescribed lower limit value, the plural number n of gain control sections 13A-1 to 13A-n keep the gain of a corresponding one of the plural number n of frequency converting sections 11-1 to 11-n at such a value that a difference between the level of the second output signal instead of the level selected by the selecting section 12A and a maximum level of signals for which all input/output characteristics of the plural number n of frequency converting sections 11-1 to 11-n can be regarded as linear among the plural number n of signals is compressed.

That is, when a second output signal generated even under automatic gain controls performed by the level variation suppressing sections 14-1 to 14-n is excessively small, the gain of the frequency converting means that has generated the corresponding first signal is kept by the gain control means corresponding to the first signal (i.e., frequency converting means) at such a value that the deviation of the second output signal is suppressed irrespective of the levels of the other first signals.

Therefore, the transmission quality can be kept higher and more flexible adaptation to a variety of profiles of radio transmission channels and wireless zones can be made than in a case that a variation or difference of the level of each of the plural number n of signals is reduced or compressed under an automatic gain control based on a maximum one of the levels of those signals.

The principle of operation of a fifth radio receiver according to the invention is as follows.

The plural number n of level variation suppressing means 14-1 to 14-n suppress level variations of the plural number n of first output signals, respectively, and thereby generate second output signals corresponding to the first output signals. When the deviation of the level of the particular output signal is larger than a prescribed threshold value and the level of a second output signal generated by one of the plural number n of level variation suppressing means 14-1 to 14-n is lower than a prescribed lower limit value, the plural number n of gain control means 13-1 to 13-n keep the gain of a corresponding one of the plural number n of frequency converting means 11-1 to 11-n at such a value that a deviation of the level of the second output signal, instead of the level of the particular output signal, is compressed.

That is, when the deviation of the level of the particular output signal selected by the selecting section 12 is larger than the prescribed threshold value and a second output signal generated even under automatic gain controls performed by the level variation suppressing means 14-1 to 14-n is excessively small, the gain of the frequency converting means that has generated the corresponding first signal is kept by the gain control means corresponding to the first signal (i.e., frequency converting means) at such a value that the deviation of the second output signal is suppressed irrespective of the levels of the other first signals.

Therefore, the transmission quality can be kept higher and more flexible adaptation to a variety of profiles of radio transmission channels and wireless zones can be made than in a case that a variation or difference of the level of each of the plural number n of signals is reduced or compressed under an automatic gain control based on a maximum one of the levels of those signals.

The principle of operation of a sixth radio receiver according to the invention is as follows.

The plural number n of level variation suppressing means 14-1 to 14-n suppress level variations of the plural number n of first output signals, respectively, and thereby generate second output signals corresponding to the first output signals. When the deviation of the level selected by the selecting section 12A is larger than a prescribed threshold value and the level of a second output signal generated by one of the plural number n of level variation suppressing means 14-1 to 14-n is lower than a prescribed lower limit value, the plural number n of gain control means 13A-1 to 13A-n keep the gain of a corresponding one of the plural number n of frequency converting means 11-1 to 11-n at such a value that a difference between the level of the second output signal instead of the level selected by the selecting section 12A and a maximum level of signals for which all input/output characteristics of the plural number n of frequency converting means 11-1 to 11-n can be regarded as linear among the plural number n of signals is compressed.

That is, when the deviation of the level of the particular output signal selected by the selecting section 12 is larger than the prescribed threshold value and a second output signal generated even under automatic gain controls performed by the level variation suppressing means 14-1 to 14-n is excessively small, the gain of the frequency converting means that has generated the corresponding first signal is kept by the gain control means corresponding to the first signal (i.e., frequency converting means) at such a value that the deviation of the second output signal is suppressed irrespective of the levels of the other first signals.

Therefore, the transmission quality can be kept higher and more flexible adaptation to a variety of profiles of radio transmission channels and wireless zones can be made than in a case that a variation or difference of the level of each of the plural number n of signals is reduced or compressed under an automatic gain control based on a maximum one of the levels of those signals.

The principle of operation of a seventh radio receiver according to the invention is as follows.

The plural number n of gain control means 13-1 to 13-n vary the gains of the plural number n of frequency converting means 11-1 to 11-n within such ranges that decreases in SN ratios of the plural number n of first output signals are permitted.

That is, even when the level of one of the plural number n of signals has become much higher or lower than the levels of the other signals for a certain reason, the frequency converting means 11-1 to 11-n operate stably in ranges where the input/output characteristics are linear.

Therefore, the plural number n of signals are converted into desired intermediate frequency signals without being distorted unduly while their level differences are reduced.

The principle of operation of an eighth radio receiver according to the invention is as follows.

The plural number n of gain control means 13A-1 to 13A-n vary the gains of the plural number n of frequency converting means 11A-1 to 11A-n within such ranges that decreases in SN ratios of the plural number n of first output signals are permitted.

That is, even when the level of one of the plural number n of signals has become much higher or lower than the levels of the other signals for a certain reason, the frequency converting means 11A-1 to 11A-n operate stably in ranges where the input/output characteristics are linear.

Therefore, the plural number n of signals are converted into desired intermediate frequency signals without being distorted unduly while their level differences are reduced.

The principle of operation of a ninth radio receiver according to the invention is as follows.

The plural number n of gain control means 13-1 to 13-n vary the gains of the plural number n of frequency converting means 11-1 to 11-n within such ranges that a desired noise figure is secured.

That is, even when the level of one of the plural number n of signals has become much lower than the levels of the other signals for a certain reason, the gains of the frequency converting means 11-1 to 11-n are updated in such ranges that the desired noise figure is secured comprehensively.

Therefore, a proper level diagram of the frequency converting means 11-1 to 11-n and the stages upstream of and downstream of the frequency converting means 11-1 to 11-n and the degree of freedom in allocating the gains to them are secured without lowering the SN ratios and the transmission quality excessively.

The principle of operation of a 10th radio receiver according to the invention is as follows.

The plural number n of gain control means 13A-1 to 13A-n vary the gains of the plural number n of frequency converting means 11A-1 to 11A-n within such ranges that a desired noise figure is secured.

That is, even when the level of one of the plural number n of signals has become much higher than the levels of the other signals for a certain reason, the gains of the frequency converting means 11A-1 to 11A-n are updated in such ranges that the desired noise figure is secured comprehensively.

Therefore, a high degree of freedom is secured in setting a level diagram of the frequency converting means 11A-1 to 11A-n and the stages upstream of and downstream of the frequency converting means 11-1 to 11-n or allocating gains to them without lowering the SN ratios or the transmission quality excessively.

The principle of operation of an 11th radio receiver according to the invention is as follows.

The plural number n of gain control means 13-1 to 13-n update the gains of the plural number n of frequency converting means 11-1 to 11-n in synchronism with sequences of symbols that are represented by the plural number n of signals, respectively.

That is, the gains of the plural number n of frequency converting means 11-1 to 11-n are updated at prescribed time points that are synchronized with respective symbol positions on which decision should be made in a process of decision decoding that is performed at a stage downstream of the frequency converting means 11-1 to 11-n.

Therefore, the SN ratios and the transmission quality are kept high even when the frequency at which the gains of the frequency converting means 11-1 to 11-n should be updated is close to the cycle of symbols that are represented by the plural number n of signals individually.

The principle of operation of a 12th radio receiver according to the invention is as follows.

The plural number n of gain control means 13A-1 to 13A-n update the gains of the plural number n of frequency converting means 11A-1 to 11A-n in synchronism with sequences of symbols that are represented by the plural number n of signals, respectively.

That is, the gains of the plural number n of frequency converting means 11A-1 to 11A-n are updated at prescribed time points that are synchronized with respective symbol positions on which decision should be made in a process of decision decoding that is performed at a stage downstream of the frequency converting means 11A-1 to 11A-n.

Therefore, the SN ratios and the transmission quality are kept high even when the frequency at which the gains of the frequency converting means 11A-1 to 11A-n should be updated is close to the cycle of symbols that are represented by the plural number n of signals individually.

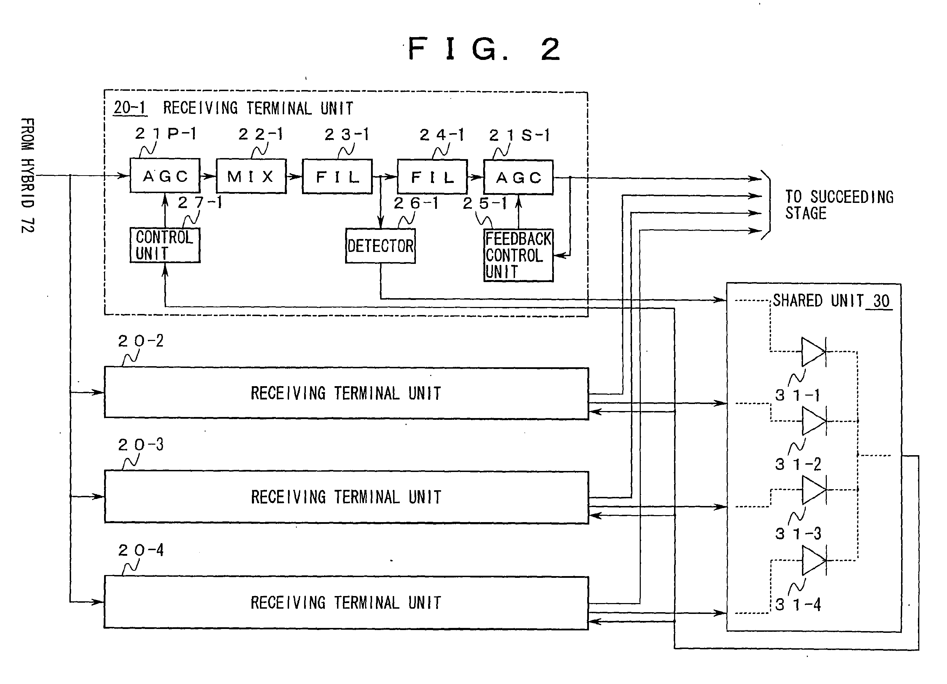

Fig. 2 shows first, second, and fourth embodiments of the invention. These embodiments are characterized in that receiving terminal units 20-1 to 20-4 shown in Fig. 2 are provided in place of the branching filters 73-1 to 73-4 and the receiving terminal units 74-1 to 74-4 shown in Fig. 5 and a shared unit 30 is provided additionally.

The receiving terminal unit 20-1 is composed of the following components:
- AGC unit (AGC) 21P-1 that is cascade-connected to a corresponding terminal of the hybrid 72 shown in Fig. 5, a frequency converting unit (MIX) 22-1, channel filtering units (FIL) 23-1 and 24-1, and an AGC unit (AGC) 21S-1.
- Feedback control unit 25-1 that is connected to the output and a control input of the AGC unit 21S-1.
- Detector 26-1 whose input is connected to the output of the channel filtering unit (FIL) 23-1 and whose output is connected to a corresponding input of the shared unit 40.
- Control unit 27-1 whose input is connected to the output of the shared unit 40 and whose output is connected to a control input of the AGC unit 21P-1.

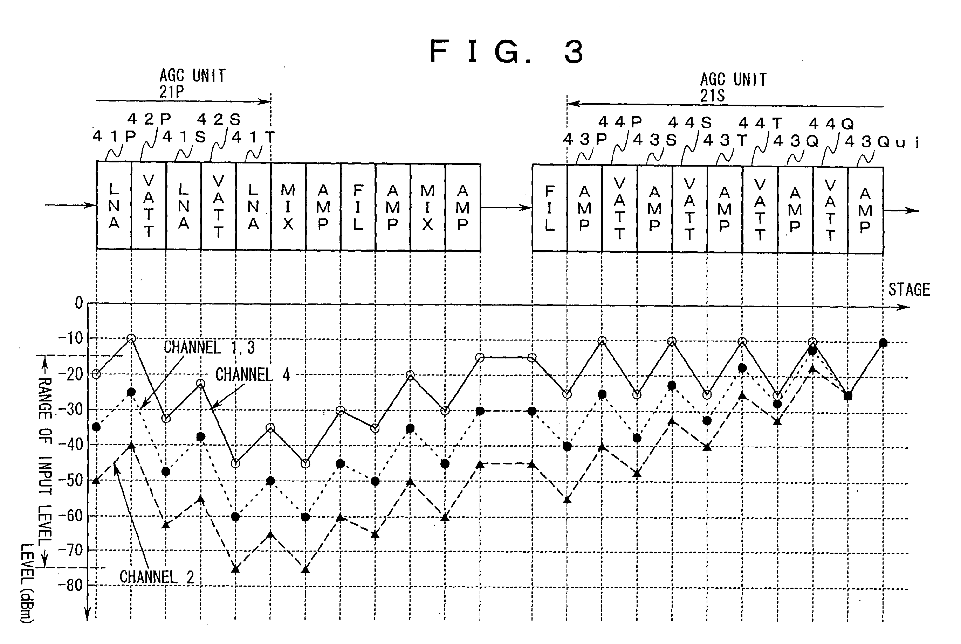

As shown in Fig. 3 with suffixes "1" to "n" omitted for the sake of simplicity, it is assumed that the AGC unit 21P-1 is composed of a low-noise amplifier (LNA) 41P-1, a variable attenuator (VATT) 42P-1, a low-noise amplifier (LNA) 41S-1, a variable attenuator (VATT) 42S-1, and a low-noise amplifier (LNA) 41T-1 that are connected to each other in cascade.

As shown in Fig. 3 with suffixes "1" to "n" omitted for the sake of simplicity, it is assumed that the AGC unit 21S-1 is composed of an amplifier (AMP) 43P-1, a variable attenuator (VATT) 44P-1, an amplifier (AMP) 43S-1, a variable attenuator (VATT) 44S-1, an amplifier (AMP) 43T-1, a variable attenuator (VATT) 44T-1, a sound amplifier (AMP) 43Q-1, a variable attenuator (VATT) 44Q-1, and an amplifier (AMP) 43Qui-1 that are connected to each other in cascade.

The configurations of the receiving terminal units 20-2 to 20-4 are the same as the configuration of the receiving terminal unit 20-1 and hence will not be described (components having corresponding components in the receiving terminal unit 20-1 will be given the same reference symbols as the latter followed by suffixes "2" to "4").

The shared unit 30 is composed of diodes 31-1 to 31-4 whose anodes are connected to the outputs of the detectors 26-1 to 26-4 provided in the receiving terminal units 20-1 to 20-4, respectively, and whose cathodes are connected to the inputs of the control unit 27-1 provided in the receiving terminal units 20-1 to 20-4, respectively.

### [Embodiment 1]

Fig. 3 illustrates the operation of the first embodiment of the invention.

The operation of the first embodiment of the invention will be described below with reference to Figs. 2 and 3.

In the following description, an item common to the receiving terminal units 20-1 to 20-4 will be given, in place of the suffixes "1" to "4," a suffix "c" indicating that it can be any of the suffixes "1" to "4."

In the receiving terminal unit 20-c, the frequency converting unit 22-c and the channel filtering unit 23-c generates an intermediate frequency signal by frequency-converting, according to a method that satisfies the following conditions, a radio-frequency signal that is distributed via the hybrid 72 shown in Fig. 5 and supplied via the AGC unit 21P-c:
- The frequency of the generated intermediate frequency signal is located in a frequency band whose bandwidth ratio is small enough to allow a pass-band of the channel filtering unit 23-c to be set accurately for an occupied band of a single, particular radio-frequency signal to be subjected to the heterodyne detection among first to fourth radio-frequency signals that are frequency-multiplexed in the above radio-frequency signal.
- The intermediate frequency signal conforms to prescribed signal processing to be performed at stages that are downstream of the AGC unit 21S-c.
- Desired levels of video frequency selectivity and effective selectivity (in a sense that a sensitivity suppression effect, crossmodulation, and intermodulation are included) are attained comprehensively.

It is assumed that pass-bands of the channel filtering units 23-c and 24-c are both set in the occupied band of the above-mentioned particular radio-frequency signal.

The AGC unit 21S-c amplifies an intermediate frequency signal (hereinafter referred to as "particular intermediate frequency signal") that is supplied via the channel filtering units 23-c and 24-c and corresponds to the above-mentioned particular radio-frequency signal and delivers it to the downstream stages (that perform demodulation, decision decoding, etc.).

The feedback control unit 25-c monitors the level of the particular intermediate frequency signal that is delivered to the downstream stages in the above manner, and keeps the gain of the AGC unit 21S-c at such a value that the difference between the level of the particular intermediate frequency signal and a reference level that was set according to a prescribed level diagram is compressed.

On the other hand, the detector 26-c generates a monitoring signal having, as an instantaneous value, a potential that is proportional to the level of the particular intermediate frequency signal obtained at the output terminal of the channel filtering unit 23-c by envelope-detecting and smoothing the particular intermediate frequency signal.

The diodes 31-1 to 31-4 provided in the shared unit 30 select a maximum one of instantaneous values of first to fourth monitoring signals that are supplied parallel in the above-described manner from the detectors 26-1 to 26-4 provided in the respective receiving terminal units 20-1 to 20-4, and generate a feedback signal that is a sequence of maximum instantaneous values thus selected.

In the receiving terminal unit 20-c, the control unit 27-c keeps the gain of the AGC unit 21P-c at such a value that the difference between the instantaneous value of the feedback signal and a standard value that was set in advance according to a prescribed level diagram and the above-mentioned instantaneous value should have is compressed.

That is, in the receiving terminal unit 20-c, the total gain of the section from the input terminal of the AGC unit 21P-c at the initial stage to the input terminal of the AGC unit 21S-c at the final stage is kept at such a value that the deviation of a maximum one of the levels of different particular radio-frequency signals that are extracted by the respective receiving terminal units 20-1 to 20-4 and are to be converted into particular intermediate frequency signals is compressed.

Therefore, according to this embodiment, even when the frequency of a radio-frequency signal is in the submillimeter wave band or a higher frequency band and the levels of individual radio-frequency signals that are frequency-multiplexed in the radio-frequency signal may be different from each other or may vary, level diagrams of the stages of the receiving terminal units 20-1 to 20-4 are kept in linear ranges without being changed to unduly small values as indicated by solid, dotted, and broken zigzag lines in the bottom part of Fig. 3 and the interchannel interference is avoided stably with high reliability.

### [Embodiment 2]

A second embodiment of the invention will be hereinafter described.

In this embodiment, the shared unit 30 is configured without the diodes 31-1 to 31-4.

The operation of the second embodiment of the invention will be described below with reference to Fig. 2.

The embodiment is characterized in the following process that is executed by the shared unit 30 and the control unit 27-c that is provided in the receiving terminal unit 20-c.

The shared unit 30 calculates an average value of errors in the signal space under a prescribed symbol position arrangement for each symbol position represented by first to fourth monitoring signals that are supplied parallel by the detectors 26-1 to 26-4 in the above-described manner.

Further, the shared unit 30 judges whether there exist monitoring signals that satisfy the following conditions among the first to fourth monitoring signals. In a period when the judgment result is false, the shared unit 30 generates a feedback signal by performing processing equivalent to the processing that is performed by the diodes 31-1 to 31-4 in the above-described first embodiment.
- The above-mentioned average value of errors is smaller than a prescribed upper limit value.
- The monitoring signals have levels that belong to a dynamic range that was given in advance according to a prescribed level diagram and in which the receiving terminal units 20-1 to 20-4 can operate in linear ranges while a desired SN ratio is secured.

In a period when the above judgment result is true, the shared unit 30 selects a particular monitoring signal having a maximum level from among the monitoring signals that satisfy the above conditions and generates a feedback signal as a sequence of peak values of instantaneous values of the particular monitoring signal.

On the other hand, in the receiving terminal unit 20-c, in a period when the above judgment result is false, as in the case of the first embodiment, the control unit 27-c keeps the gain of the AGC unit 21P-c at such a value that the difference between the instantaneous value of the feedback signal and a standard value that the instantaneous value of the feedback signal should have is compressed.

In a period when the above judgment result is true, the control unit 27-c keeps the gain of the AGC unit 21P-c at such a value that the difference between the instantaneous value of the feedback signal and the upper limit of the above-mentioned dynamic range is compressed.

That is, in the receiving terminal unit 20-c, the total gain of the section from the input terminal of the AGC unit 21P-c at the initial stage to the input terminal of the AGC unit 21S-c at the final stage is kept at such a value that the deviation of the level of a radio-frequency signal having highest transmission quality among different particular radio-frequency signals that are extracted by the respective receiving terminal units 20-1 to 20-4 and are to be converted into intermediate frequency signals is compressed.

Therefore, according to this embodiment, the stages of the receiving terminal units 20-1 to 20-4 are kept in linear ranges more reliably and the interchannel interference is avoided more stably than in the above-described first embodiment in which such a deviation is determined on the basis of the level of a particular radio-frequency signal merely having a maximum level among the above-mentioned different particular radio-frequency signals.

In each of the above embodiments, the control unit 27-c updates the gain of the AGC unit 21P-c without synchronizing with the above-mentioned radio-frequency signal or feedback signal at all.

However, the invention is not limited to such a case. For example, undue deterioration or lowering of the transmission quality may be avoided by updating the gain of the AGC unit 21P-c with symbol-by-symbol synchronization with a particular monitoring signal that is selected by the shared unit 30.

### [Embodiment 3]

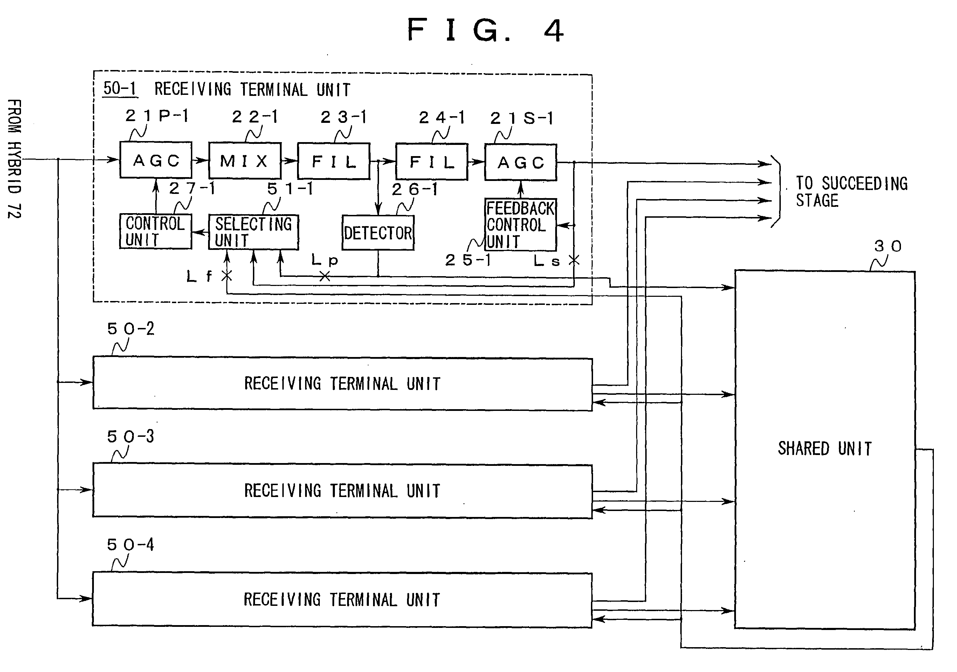

Fig. 4 shows the third embodiment of the invention.

This embodiment is provided with receiving terminal units 50-1 to 50-4 in place of the receiving terminal units 20-1 to 20-4 shown in Fig. 2.

The receiving terminal unit 50-1 is the same in configuration as the receiving terminal unit 20-1 except that a selecting unit 51-1 is provided immediately upstream of the control unit 27-1 shown in Fig. 2 and the outputs of the shared unit 30, the feedback control unit 25-1, and the detector 26-1 are connected to first to third inputs of the selecting unit 51-1.

The configurations of the receiving terminal units 50-2 to 50-4 are the same as the configuration of the receiving terminal unit 50-1 and hence will not be described in detail (components having corresponding components in the receiving terminal unit 50-1 will be given the same reference symbols as the latter followed by suffixes "2" to "4" instead of "1").

The operation of the third embodiment of the invention will be described below with reference to Fig. 4.

An item common to the receiving terminal units 50-1 to 50-4 will be given, in place of the suffixes "1" to "4" corresponding to the receiving terminal units 50-1 to 50-4, a suffix "c" indicating that it can be any of the suffixes "1" to "4."

In the receiving terminal unit 50-c, the selecting unit 51-c performs the following processing:
(1) Takes in an instantaneous value Lf-c of a feedback signal generated by the shared unit 30, an instantaneous value Lp-c of a monitoring signal supplied from the detector 26-c, and a level Lp-c of a particular intermediate frequency signal obtained at the output of the channel filtering unit 23-c.
(2) Judges whether all of the following conditions are satisfied for the above levels Lp-c and Lf-c and a level Ls-c that is monitored by the feedback control unit 25-c in the above-described manner.
   1) The level Ls is lower than a lower limit value that was set in advance according to a prescribed level diagram.
   2) The level Lp is lower than the above-mentioned level Lf-c by a reference value (e.g., 10 dB) that was set in advance according to the above level diagram.
   3) When the result of the above judgment is false, the selecting unit 51-c selects the above-mentioned feedback signal and supplies the selected feedback signal to the control unit 27-c as in the case of the above-described first or second embodiment.
   4) However, when the result of the above judgment is true, the selecting unit 51-c selects the above-mentioned monitoring signal and supplies the selected monitoring signal to the control unit 27-c instead of the feedback signal.

That is, when the level of a particular radio-frequency signal that has been extracted by the AGC unit 21P-c, the frequency converting unit 22-c, and the channel filtering unit 23-c and converted into a particular intermediate frequency signal has decreased much to such an extent that the result of the above judgment becomes false, the control unit 27-c reduces or compresses the large level decrease on the basis of the instantaneous value of the monitoring signal that is output from the detector 26-c rather than that of the feedback signal that is output from the shared unit 30.

Therefore, even when any of first to fourth radio-frequency signals to be demultiplexed and frequency-converted by the respective receiving terminal units 50-1 to 50-4 is received at a much lower level than the other radio-frequency signals due to a multipath phenomenon or the like, the level decrease is reduced or compressed under the processing that is performed in the above-described manner by the selecting unit 51-c of the corresponding receiving terminal unit 50-c.

As described above, according to this embodiment, the transmission quality can be kept higher and more flexible adaptation to a variety of profiles of radio transmission channels and wireless zones can be made than in a case that a variation or difference of the level of each of first to fourth radio-frequency signals that are transmitted parallel via respective frequency-multiplexed channels is reduced or compressed under an automatic gain control based on a maximum one of the above levels.

In this embodiment, the selecting unit 51-c selects a signal to be supplied to the control unit 27-c on the basis of a result of the judgment as to whether both of the conditions 1) and 2) of item (2) are satisfied.

However, the invention is not limited to such a configuration. For example, the configuration and the processing may be simplified by making a judgment as to whether only one of the conditions 1) and 2) of item (2) is satisfied, as long as it does not impair the above-mentioned level diagram or fulfillment of any other technical requirement.

In this embodiment, the selecting unit 51-c selects only the above-mentioned monitoring signal as a signal to be supplied to the control unit 27-c instead of the feedback signal.

However, the invention is not limited to such a configuration. For example, where the level of the intermediate frequency signal that is supplied from the AGC unit 21S-c to the stages downstream of the AGC unit 21S-c may become excessively low, the selecting unit 51-c may select, instead of the feedback signal, a signal to be supplied to the control unit 27-c by performing one of the following pieces of processing and thereby secure more stable transmission quality:
- Refers to, in the above-described judgment, a signal (hereinafter referred to as "level monitoring signal") indicating, as an instantaneous value, a level that is monitored by the feedback control unit 25-c, and supplies it to the control unit 27-c where appropriate on the basis of a result of the judgment.
- Makes, in addition to the above-described judgment, a judgment as to whether the level indicated by the level monitoring signal has become excessively low and, when the result of the latter judgment is true, supplies the level monitoring signal to the control unit 27-c with priority given to it over the monitoring signal.

### [Embodiment 4]

The operation of the fourth embodiment of the invention will be described below with reference to Figs. 2 and 4.

This embodiment is characterized in the following processing that is performed by the control unit 27-c that is provided in the receiving terminal unit 20-c or 50-c.

The control unit 27-c is given in advance, as known information, a range (hereinafter referred to as "prescribed range" of a gain to be set in the AGC unit 21P-c that satisfies all or part of the following conditions:
- The deterioration in the SN (or CN) ratio of a radio-frequency signal to be received via the receiving terminal unit 20-c or 50-c is suppressed to within an allowable limit.
- The deterioration in the total noise figure of the receiving terminal unit 20-c or 50-c is suppressed to within an allowable limit.
- The individual units operate in a linear range under a prescribed level diagram or the level of distortion that is caused by nonlinearity of the individual units is suppressed to within an allowable limit.

Basically, the control unit 27-c sets as appropriate and updates the gain of the AGC unit 21P-c in the manner described in one of the first to third embodiments. When a new gain to be set in the AGC unit 21P-c is out of the above-mentioned prescribed range, the control unit 27-c performs one of the following pieces of processing:
- Refrains from setting the new gain.
- Sets, in the AGC unit 21P-c, a gain having a minimum error from the new gain among gains in the prescribed range.

Therefore, according to this embodiment, flexible adaptation to all or part of the following items can be made and high transmission quality can be secured stably as long as the above-mentioned prescribed range is given in advance with a proper level of accuracy:
- Circuit types and characteristics deviations of the individual units of the receiving terminal unit 20-c or 50-c.
- Total level diagram that is set in advance between a transmitting end and a receiving end.
- Transmission characteristics of radio transmission channels (including profiles of wireless zones, weather conditions, etc.).
- Transmitting power control that may be performed in the transmitting end.

In each of the above embodiments, the gain of the AGC unit 21P-c is varied according to the feedback method.

However, the invention is not limited to such a configuration. For example, differences between the levels of respective channels may be compressed by varying the following gain as appropriate instead of or in addition to the gain of the AGC unit 21P-c:
- The gain of one or both of the AGC unit 21S-1 and the channel filtering unit 24-c.
- The gain of a variable gain amplifier that is added upstream of the AGC unit 21S-1 or the channel filtering unit 24-c (or the attenuation factor of a variable attenuator in the case where the variable attenuator is added instead of a variable amplifier).

In each of the above embodiments, the frequency converting unit 22-c performs frequency conversion two times to set the bandwidth ratio of each channel to such a small value that the pass-bands of the channel filtering units 23-c and 24-c are set so as to have the same width as their occupied band width accurately at a low cost.

However, in the receiving terminal unit 20-c or 50-c, as long as the pass-bands of the channel filtering units 23-c and 24-c are set in the above-described manner, the total number of times of frequency conversion performed by one or both of the frequency converting unit 22-c and the downstream stages of the AGC unit 21S-c may be any number.

That is, the invention can be applied to, instead of the double superheterodyne method, the homodyne detection method (direct conversion method) and the triple superheterodyne method in similar manners.

In each of the above embodiments, the receiving terminal unit 20-c or 50-c performs the above-described processing with an assumption that the occupied bands of channels corresponding to the respective receiving terminal units 20-c or 50-c satisfy all of the following conditions:
- Are adjacent to each other on the frequency axis and are frequency-multiplexed.
- Have a common occupied band width.

However, in the invention, the channel configuration and the frequency allocation are not limited to those in such a case. For example, where the occupied band width varies from one channel to another, the above-mentioned level may be calculated as a density (average value) of power (frequency spectrum) in the occupied band of a channel concerned.

In the above embodiments, the invention is applied to the configurations of the access systems using the multiplex radio transmission in the submillimeter wave band or a higher radio frequency band.

However, the application field of the invention is not limited to such access systems. For example, the invention can also be applied to construction of a long-span communication link (access system) in which multi-hopping and frequency reuse in the submillimeter wave band is attained to solve a shortage of frequencies.

In each of the above embodiments, the gain of the AGC unit 21P-1 is set and updated as appropriate by the control unit 27-c with an assumption that the instantaneous value of each of a feedback signal, a monitoring signal, and a level monitoring signal is proportional to the level of a corresponding radio-frequency signal or intermediate frequency signal.

However, the invention is not limited to such a configuration. For example, when the above-mentioned condition is not satisfied for any of the feedback signal, the monitoring signal, and the level monitoring signal, conversion processing for making the condition satisfied may be performed by all or part of the following units:
- The shared unit 30, the detector 26-c, and the feedback control unit 25-c corresponding to the feedback signal, the monitoring signal, and the level monitoring signal, respectively.
- Control unit 27-c
- Selecting unit 51-c

In each of the above embodiments, each of the receiving terminal unit 20-c or 50-c and the shared unit 30 is formed as dedicated hardware.

Alternatively, the whole or part of one or both of the receiving terminal unit 20-c or 50-c and the shared unit 30 may be a general-purpose processor (may be a DSP) incorporating software that realizes processing that is equivalent to the above-described processing.

Further, in each of the above embodiments, a plurality of (four) radio-frequency signals that are frequency-multiplexed and are phase-modulated individually are input to the receiving terminal unit 20-c or 50-c in parallel.

However, the modulation method that is used for generating such radio-frequency signals is not limited to the phase modulation method. As long as deterioration (symbol position errors) in transmission quality that is caused by updating of the gain of the AGC unit 21P-c is so small as to be allowable or decision decoding, transmission channel decoding, or some other technique capable of making deterioration in transmission quality sufficiently small is used separately, various modulation methods such as QAM in which the distances between all symbol positions in the signal space and the origin of the signal space are not the same.

The invention is not limited to the above embodiments and various modifications may be made without departing from the spirit and scope of the invention. And any improvements may be made in all or part of the components and units.

## Claims

1. A radio receiver comprising:
a plural number n of frequency converting sections frequency-converting a plural number n of frequency-multiplexed signals, respectively, and thereby generating a plural number n of first output signals corresponding to said respective frequency-multiplexed signals;
a selecting section selecting a particular output signal having a maximum level from among said plural number n of first output signals; and
a plural number n of gain control sections keeping gains of said plural number n of frequency converting sections in parallel at such a value that a deviation of a level of said particular output signal is compressed.

2. A radio receiver comprising:
a plural number n of frequency converting sections frequency-converting a plural number n of frequency-multiplexed signals, respectively, and thereby generating a plural number n of first output signals corresponding to said respective frequency-multiplexed signals;
a selecting section selecting a level of a particular signal having highest transmission quality from among levels of said plural number n of first output signals; and
a plural number n of gain control sections keeping gains of said plural number n of frequency converting sections, respectively, at such a value that a difference between said level selected by said selecting section and a maximum level of signals for which all input/output characteristics of said plural number n of frequency converting sections can be regarded as linear among said plural number n of signals, is compressed.

3. The radio receiver according to claim 1, further comprising a plural number n of level variation suppressing sections suppressing level variations of said plural number n of first output signals, respectively, and thereby generating second output signals corresponding to said first output signals, wherein
when a level of one of said second output signals generated by said plural number n of level variation suppressing sections, respectively, is lower than a prescribed lower limit value, said plural number n of gain control sections keep said gain of corresponding one of said plural number n of frequency converting sections at such a value that a deviation of the level of said second output signal, instead of the level of said particular output signal, is compressed.

4. The radio receiver according to claim 2, further comprising a plural number n of level variation suppressing sections suppressing level variations of said plural number n of first output signals, respectively, and thereby generating second output signals corresponding to said first output signals, wherein
when a level of one of said second output signals generated by said plural number n of level variation suppressing sections, respectively, is lower than a prescribed lower limit value, said plural number n of gain control sections keep said gain of corresponding one of said plural number n of frequency converting sections at such a value that a deviation of the level of said second output signal, instead of the level of said particular output signal, is compressed.

5. The radio receiver according to claim 1, further comprising a plural number n of level variation suppressing sections suppressing level variations of said plural number n of first output signals, respectively, and thereby generating second output signals corresponding to said first output signals, wherein
when said deviation of the level of said particular output signal is larger than a prescribed threshold value and a level of one of said second output signals generated by said plural number n of level variation suppressing sections, respectively, is lower than a prescribed lower limit value, said plural number n of gain control sections keep said gain of corresponding one of said plural number n of frequency converting sections at such a value that a deviation of the level of said second output signal, instead of the level of said particular output signal, is compressed.

6. The radio receiver according to claim 2, further comprising a plural number n of level variation suppressing sections suppressing level variations of said plural number n of first output signals, respectively, and thereby generating second output signals corresponding to said first output signals, wherein
when said deviation of the level of said particular output signal is larger than a prescribed threshold value and a level of one of said second output signals generated by said plural number n of level variation suppressing sections, respectively, is lower than a prescribed lower limit value, said plural number n of gain control sections keep said gain of corresponding one of said plural number n of frequency converting sections at such a value that a deviation of the level of said second output signal, instead of the level of said particular output signal, is compressed.

7. The radio receiver according to claim 1, wherein said plural number n of gain control sections vary said gains of said plural number n of frequency converting sections within such ranges where decreases in SN ratios of said plural number n of first output signals are permitted.

8. The radio receiver according to claim 2, wherein said plural number n of gain control sections vary said gains of said plural number n of frequency converting sections within such ranges where decreases in SN ratios of said plural number n of first output signals are permitted.

9. The radio receiver according to claim 1, wherein said plural number n of gain control sections vary said gains of said plural number n of frequency converting sections within such ranges that a desired noise figure is secured.

10. The radio receiver according to claim 2, wherein said plural number n of gain control sections vary said gains of said plural number n of frequency converting sections within such ranges that a desired noise figure is secured.

11. The radio receiver according to claim 1, wherein said plural number n of gain control sections update said gains of said plural number n of frequency converting sections in synchronism with sequences of symbols that are represented by said plural number n of signals, respectively.

12. The radio receiver according to claim 2, wherein said plural number n of gain control sections update said gains of said plural number n of frequency converting sections in synchronism with sequences of symbols that are represented by said plural number n of signals, respectively.
